Europäisches Patentamt

European Patent Office

Office européen des brevets

(11) Publication number: **0 595 377 A1**

## EUROPEAN PATENT APPLICATION

(21) Application number: **93201470.7**

(22) Date of filing: **24.05.93**

(51) Int. Cl.5: **H03L 7/23**

(30) Priority: **29.10.92 IT MI922485**

(43) Date of publication of application:
**04.05.94 Bulletin 94/18**

(84) Designated Contracting States:
**BE DE ES FR GB NL SE**

(71) Applicant: **MIZAR S.p.A.**
**Via Milano 46**
**I-22050 Lomagna (CO)(IT)**

(72) Inventor: **Nicotra, Sebastiano**
**Strada dei Roncà; 2**
**I-22050 Paderno d'Adda (CO)(IT)**
Inventor: **Tosini, Roberto**
**Via Pio XI, 9**
**I-20050 Ronco Briantino (MI)(IT)**

(74) Representative: **Incollingo, Italo**
**Piazzale Lavater, 3**
**I-20129 Milano (IT)**

(54) **Frequency synthesis system for generating microwave oscillations.**

(57) The frequency synthesis system for generating microwaves comprises a main loop (AP) with a low merit factor VCA covering the whole requested band with an electronic tuning, and a secondary loop (AS) including an indirect synthesis single-loop section with a critical oscillator (O1), and a second section wherein the frequencies necessary for the synthesis are generated by direct way from a reference quarz (R1) which controls also the stability of said (O1) oscillator.

FIG. 4

## Background of the invention

The invention refers to frequency synthesis systems for the generation of high-frequency signals, in particular of microwaves; more specifically the invention concerns frequency synthesised microwave oscillators including a direct synthesis section preferably in single loop form, and an indirect synthesis section in multiple loop form, said oscillators being characterized by high performances, high reliability, minimum structure complexity and very low wastes in terms of cost and energy consumption.

For illustrative aims, the oscillators according to the invention allow to obtain the performances of indirect frequency synthesized multiple loop oscillators with the cost highly lower of the single loop frequency synthesized oscillators; they are mainly used in low capacitor radio communication systems and/or in systems in which it is required a completely electronic frequency setting.

The invention includes also some specific implementations that are particularly simple and efficient.

## State of the Art

The frequency synthetized oscillators have actually a more and more increasing diffusion and are notoriously of the direct or indirect synthesis types having simple or multiple loop.

Just for fixing the ideas, the Figures from 1 to 3 represent typical schemes of these synthesis types.

## Direct frequency synthesis

The more simple approach is that of selecting one of several oscillators, each tuned on each of the required frequencies, using an electronic microwave commutator.

This method is obviously applied in the sole case in which the number of frequencies to be synthetized is rather limited.

Normally less immediate methods are used, but they allow to greatly reduce the number of necessary microwave oscillators.

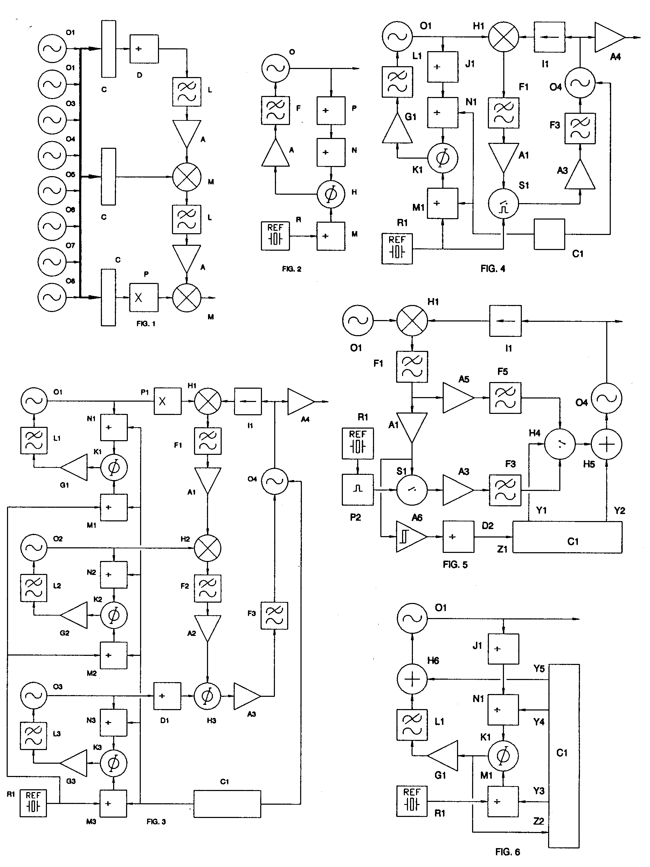

Figure 1 shows one of possible methods, in which 01....08 are 8 oscillators, directly obtained by quartz cristals or by multiplication, or cavities stabilized at different frequencies, C are 8-way commutators, L are filters, D are dividers by 8, A are buffer amplifiers, M are mixers, P are multipliers.

If the frequency difference between two successive oscillators is F, the synthesis step is F/8 and the total covered band is: 8x8x8xF/8 = 64xF. The number of used components, and then the cost, is particularly high, but it is possible to get a rather high commutation speed from a frequency to another frequency, in a time even under a microsecond.

## Indirect single loop synthesis

The principle scheme is represented in Figure 2.

O is a microwave VCO that covers the required frequency band, P is a prescaler (a fixed microwave divider), N and M are programmable low-frequency dividers, H is a phase and frequency comparator, R is a reference quartz oscillator, A is an amplifier and F is a filter, always at very low frequencies, necessary for assuring the stability of the phase control loop.

By suitably programming the dividers N and M a microwave frequency equal to $(R/M)xNxP$ is obtained. As the obtained performances are susbstantially determined by the microwave VCO, to reach the results required by the radio-commmunication systems, recourse is made to a cavity oscillator mechanically tuned at a frequency near to the required frequency and with a rather limited electronic tuning band. The scheme is relatively simple and, although for getting the required performances it is necessary to use sophisticated technologies, the total cost is not very high.

This scheme is however rather unpratical becouse the tuning operation must be made in laboratory (it is not fully obtained electrically), and the performances also depend on the ability with which the mechanical pre-tuning operation is carried out.

## Indirect multiple loop synthesis

The problems shown in the single-loop frequency synthesis are solved using the multiple-loop technics with the drawback of requiring a high circuit complexity.

The Figure 3 shows one of the many possible schemes, that for illustrative aims is limited to the case of three loops.

O4 is a microwave VCO with low gain factor that covers completely the band required with its electronic tuning.

A buffer amplifier A4 is interposed between the oscillator O4 and the output of signal RF.

A part of the signal of oscillator O4 is sent to the mixer H1 by means of the isolator I1, necessary for avoiding spurious frequencies at the main output.

Its frequency is progressively down-shifted through the mixers H1, H2, H3 (this last mixer is made with a phase/frequency comparator for closing again the main loop).

A1, F2, A2, and F2 are amplifiers and filters at the two intermediate frequencies and A3 and F3 are amplifier and low frequency filter for closing again the loop.

P1 is a frequency multiplier and D1 is a frequency divider. O1, O2 and O3 are oscillators, usually at UHF frequency, also these synthetized on a sufficiently little frequency number, generally by means of indirect single loop.

N1, M1, N2, M2, N3, M3 are programmable frequency dividers, necessary to establish the frequency of O1, O2, and O3.

K1, K2 and K3 are the related phase/frequency comparators; G1, G2 and G3 are the low-frequency amplifiers; L1, L2 and L3 are the loop filters.

A microcontroller C1 pre-tunes the oscillator O4 at a frequency near to the wished frequency by means of a digital/analog converter and programs correctly the programmable dividers N1, M1, N2, M2, N3 and M4.

R1 is the frequency reference obtained by a quartz oscillator.

As the main loop does not include any frequency divider, the performances of the oscillator O4 have no determinant influence onto the performances of the total device.

The performances of the oscillator O3 are increased by the divider D1, and O3 carries out a great number of frequency fine steps, that are the more critical.

The performances of oscillator O2 influence directly the performances of the total device, although they are at sufficiently low frequency (no more than some hundreds of MHz), that gets the required results without great difficulties; then it syntetizes the intermediate frequency steps.

The oscillator O4 is the more critical element as its performances influence the total device that are worsened by the multiplication order P1; it synthetizes few great frequency steps (the less critical ones) and in some cases it is preferable that it is made by direct synthesis (instead of by indirect synthesis as indicated in figure).

The mixer G1 and multiplier P1 assembly is frequently made-up with a sole sampling circuit (sampler), that makes the harmonic frequency conversion with equal results.

Summary of the invention

The object of this invention is to provide an oscillator system, that does not show the drawbacks of the devices of the prior Art and allows to get performances at least comparable if not higher than the ones of an indirect multiple-loop frequency synthesis oscillator, with a minor structure and circuit complexity and with very low waste in terms of costs, overall dimensions, maintenance, etc..

Another object of the invention is to provide a highly flexible system suitable for generating oscillation frequencies included within a wide band without great variants with respect to the base scheme, that can cover e.g. the ranges from UHF frequencies until the higher microwave frequencies, keeping identical a great part of circuits and modifying the sole RF parts.

These and other objects are achieved by the systems and devices according to the invention, whose more peculiar characteristics are specified in the claims.

The different features and advantages of the invention shall better appear from the following description of the preferred but not limitative embodiments represented in the drawings, in which the Figures 4, 5 and 6 are, similarly to former Figures from 1 to 3, circuit block schemes.

The Figure 4 complexively shows the scheme according to the invention that allows to get the performances of a multiple-loop frequency synthesis oscillator with a circuit complexity, and then a cost, slightly higher than the one obtained with the single loop.

The system is made-up of a main loop (AP) and of a secondary loop (AS). The loop AP has the oscillator O4 that is formed, according to a feature of the invention, by a low gain factor microwave VCO that covers entirely the required band with its electronic tuning.

Between the oscillator O4 and the RF signal output it is interposed a buffer amplifier A4.

A part of the signal of oscillator O4 is sent to the mixer H1 through the insulator I1, necessary for avoding spurious frequencies at the main output.

The frequency of O4 is also here down-shifted through the mixer H1 from the oscillator O1 that forms a first section Z1 of the secondary loop AS. According to a feature of the invention, the oscillator O1, determinant for getting the required performances, is a cavity oscillator with very high gain factor, without mechanical tuning, weakly tunable by electric means.

The electric tuning allows to synthetize the fine frequency steps and to control the stability of the cavity oscillator with a quartz reference R1.

For getting this, said section Z1 of AS includes a frequency synthesis single-loop including the programmable dividers N1 and M1, the phase/frequency comparator K1, the low frequency amplifier G1 and the loop filter L1.

Upstream the programmable divider N1 it is preferably inserted a fixed frequency divider (prescaler) J1.

Also if this scheme part can be considered similar to the scheme of a single loop frequency synthesis oscillator, it now differs advantageously in that the cavity oscillator, not being provided with mechanical tuning, is much less critical.

The frequency converted by H1 is also here filtered by F1 and amplified by A1, but in this case, as it is possible to convert both the lateral higher band and the inferior lateral band, and being also possible to obtain the isofrequency beat, the intermediate frequency (fi) outgoing from the mixer H1 can range from the direct current until about 1 GHz current.

Therefore it is possible to cover by O4 a frequency e.g. from 1 GHz lower until 1 GHz higher than the frequency of O1, covering in this manner complexively a band e.g. of 2 GHz.

The greater frequency steps are obtained hooking (controlling) the above mentioned intermediate frequency, coming from A1, to multiple the values of the reference frequency R1 by means of a low frequency sampling circuit S1 (section Z2 of the secondary synthesis loop ASJ). A3 and F3 are amplifier and low frequency filter that close the main control loop.

Also here the microcontroller C1 pretunes at a frequency near to the wished frequency O4 using a digital/analog converter and correctly programs the programmable dividers N1 and M1.

This scheme can be embodied for the frequencies from the UHF frequencies until the higher microwave frequencies that are actually used in telecommunications, keeping strictly identical a great part of circuits and modifying the sole RF parts, that is O4, A4, I1, H1, O1, J1.

Considering that the element more critical and determinat for the total performances, that is the oscillator O1, is highly simplified due to the absence of the mechanical tuning, and the remaining circuits are always identical in each frequency range and/or do not show particular technological difficulties, the complexity of the proposed scheme (and then the cost) does not appear sensitively higher than the one of a single loop frequency oscillator with cavity oscillator tunable by mechanical means.

On the contrary the performances and use practicalness are greatly higher.

**Performances**

Oscillation frequency.

It is possible to obtain oscillating frequencies from 1 HGz to 20 GHz without variants to the scheme shown in Figure 4.

For obtaining lower frequencies it is convenient to join a frequency divider at output, for higher frequencies it is convenient to add a multiplier.

Synthetizable frequency range.

It depends mainly from the sampler S1 and the multiplication order that it is desired to apply to the reference R1 (Figure 4).

It is particularly easy and economic to cover 300 MHz below and 300 MHz above the oscillation frequency of O4, however by accepting higher multiplying orders and making more sophisticated sampling circuits it is possible to get also bands of some GHz.

Minimum synthesis step.

It depends on the secondary synthetis loop related to the cavity oscillator O1 (Figure 4).

No limitations are present except the increase of the time required for the synthesis of a new frequency, inversely proportional to the minimum step.

Frequency synthesis time.

It depends on the microcontroller speed C1 and on the band width of filter L1, depending on the synthesis step and the division order of prescaler J1 (Figure 4).

If the microcontroller has ended all necessary calculations in some microseconds, e.g. 10 mSec, with a synthesis step of 100 kHz and a prescaler division order 8, a synthesis time of about $500 \times (8/100) + 10 = 50$ mSec is obtained.

Frequency stability versus temperature.

It only depends on the reference oscillator R1, it is easy to obtain a stability of 5 ppm (parts per million) in the temperature range from -20° to +70°C.

Frequency stability versus time (aging).

It depends only on the reference oscillator R1, it is easy to obtain a stability of 3 ppm (parts per million) per year.

In any case it can be foreseen an external adjustment for the recovering of oscillation frequency.

Frequency stability versus frequency variations (pushing).

It depends only on the reference oscillator R1, admitting that the feeding variations were not suitable to allow the correct running of the whole device.

It is a good rule to insert the suitable tension governors on the feeding for bringing again the frequency variations to tenths or hundredths of ppm/V in consequence of feeding variations.

Frequency stability versus output load variations (pulling).

The frequency, depending on the sole R1 value, does not change with the load change.

The insulation assured by the buffer A4 allows the good running of oscillator also in presence of a total reflection, with any phase, starting from the load value.

Frequency stability in consequence of mechanical stresses (microphonics).

As long as the mechanical stresses have a low intensity, the microfonics depends only on the reference quartz oscillator R1, that for this aim shall be conveniently installed on elastic buffers.

With increasing mechanical stresses, releasing fenomena could occur in the synthesis second loop: O1, J1, N1, K1, G1, L1 (Figure 4).

This phenomenon can be attenuated by adopting some circuit solutions, described in the following, with the aim of obtaining 5 ppm deviation of the frequency in conjunction with shocks of 50 mJ, corresponding to accelerations of about 500 g, having a duration of about 0.1 msec.

Phase noise of the oscillation frequency.

The single side band phase noise depends on the oscillator O1 and on the multiplying order of reference R1 within the main synthesis loop band, whih is determined by the filter F4, and by the external oscillator O4 (Figure 4).

A correct dimensioning of the device should allow to obtain at least 85 dBc/Hz at 1 ppm from the carrier, 100 dBc/Hz at 10 ppm and 110 dBc/Hz at 100 ppm and higher values from the main band.

Spurious frequencies in the oscillation band.

The content of spurious frequencies depends obviously on the good quality of the circuit disposition, however the insulator I1 (Figure 4) has a leading rôle on the content of output spurious frequencies.

Supposing equal to 30 dB the insulation of the mixer H1 and that of oscillators O1 and O4 about equal to said insulation, 50 dB of insulation in I1 are necessary to obtain more than 80 dBc at output.

The task could be made easier by slightly modifying the scheme of Figure 4.

Moving J1 to the place of I1, and correspondingly the frequency of O1, it is possible to carry out the mixing in H1 at a frequency lower (submultiple) than the frequency of O4 with a consequent reduction of the output spurious frequencies at the detriment of an increase of the total phase noise.

Spurious (harmonic) frequencies outside the oscillation band.

The harmonic content of VCO O4 (Figure 4) is sufficiently high, as the device has a low gain factor and moreover it is further increased by the buffer A4 that must suitably act also as limiter for levelling as far as possible the output power.

Therefore it is convenient to insert a low-pass filter at the RF output, after A4, for bringing the content of harmonic frequencies under 30 dBc.

Transient spurious frequencies during the frequency tuning operations.

If the mlcrocontroller C1 holds in memory the tension/ frequency characteristic of O4, it is possible to cut off O4 and A4 during the tuning operations, to insert them again in proximity of the wished frequency.

Therefore it is possible to obtain an emission of spurious frequencies during the tuning operations under 100 dBc.

Output power, its variation in band and in temperature.

The device performances, as regards the output power, depend solely on the buffer A4 (Figure 4), that is unessential in the proposed scheme.

It is easy to obtain 15 dBm of output power with 0.5 dB variation in temperature and 1.5 dB variation in band, that are performances typical in the field of local oscillators for microwave communication systems.

Feeding.

The parts that contribute in greater measure to the device power absorption are the prescaler J1, the oscillators O1 and O4 and the buffer A4 (Figure 4).

The proposed scheme allows to keep a consumption at a rather low level, from about 2 W under 2 GHz until 5 W over 10 GHz.

Mechanical dimensions.

The circuit simplicity allowed by the proposed scheme allows to obtain highly reduced dimensions also using the more traditional and economic technologies, printed circuits on glass fibre for the lower frequencies and on fluorine polymers (teflon) for the microwaves.

It is possible to obtain dimensions of about 200 cubic centimeters without using sophisticated technics of circuit integration.

## PARTICULAR CIRCUIT SOLUTIONS

For examining in better details the problems related to the embodiment of the proposed device, it is advisable to break the scheme of Figure 4 in two loops, the main loop (AP), formed by O4, I1, H1, F1, A1, S1, A3 and F3 (Figure 5) and the secondary loop (AS) (Figure 6) formed by O1, J1, N1, K1, G1 and L1, where K1 is a phase/frequency comparator.

The amplifier A4 is unessential for the good running of the scheme and is only used for adjusting the output power at the required value.

The reference oscillator R1 is a normal quartz oscillator, eventually thermostat controlled for getting the best stability.

The divider M1 is used only for getting the minimum required synthesis step, equal to the frequency of R1 divided by M1 and multiplied by J1, and it is normally inserted in the inside of a sole integrated circuit together with N1 and K1, easily available on the market from various suppliers at low cost.

The microcontroller C1 has the task of transforming the wished oscillation frequency, signaled by data in binary code transmitted in series or in parallel, in actions to be taken on the main and secondary synthesis loop.

Therefore it shall preferably include in addition to standard arithmetic functions, memory, etc., also analog inputs and outputs, a counter/timer, at least a serial port and a parallel port for the interface with external devices, and further other digital inputs and outputs for device control signals.

### The main synthesis loop AP

Although the scheme represented in Figure 4 can be immediately transformed in components necessary for the good running, the variant represented in Figure 5 allows to optimize the performances without making more complex the single parts of the circuit.

Therefore the detailed description of used components shall be made with reference to Figure 5.

The embodiment of microwave VCO O4 does not involve serious difficulties.

The used active component is a transistor for the lower frequencies and a fet for the higher frequencies.

The frequency tuning is obtained by a varactor diode of the iperquick type, normally it is not necessary to use a resonator YIG.

The high impedance input of said varactor forms the node of tension sum H5.

The tuning linearity, in MHz/V, is not particularly important, as it can be accepted also a doubling of the sensitivity between the high and low band limits.

It is not necessary to control the stability in temperature, it is only sufficient that it covers the range required in the foreseen temperature range.

The output power can be also of some mW, sufficient for piloting the mixer H1, with range variations also amounting to some dB.

The phase noise of the oscillator O4 influences the performances of the total device only out of the band of control loop, in the order of 300 or 400 KHz.

Therefore it is easy to obtain the required results at a so high distance from the carrier frequency.

The insulator I1 has the sole aim of avoiding that the residue of the oscillator O1 emerging from the mixer H1, reaches the output.

It is preferably made-up of some buffer stages formed by transistors or fets at the lower frequencies and with one or two passive insulators in cascade on ferrites or garnets at the higher frequencies.

It is easy to understand that about 50 dB insulation are sufficient for assuring a residue lower than 80 dBc at output.

The insulator I1 can be replaced with a frequency divider, e.g. a divider by 4 times.

In this case the oscillator O1 and the mixer H1 work at 1/4 of the frequency of O4, the spurious frequency at output is only caused by distortions that generate a fourth harmonic of the frequency of O1, normally sufficiently low.

But in this case the phase noise in proximity of the carrier frequency increases by 4 times, that is 12 bB.

The mixer H1, normally made-up with Shottky-junction diodes is of the simple balanced type, and it is necessary to adjust the insulation between the two radiofrequency inputs and the distortion of the output in low frequency.

The signal at output of the mixer H1, that includes the direct current for allowing the hooking of the oscillator O4 to the same frequency of O1, should have rather low harmonic and spurious distortions together with as high as possible level.

It is easy to obtain a level of about 0.1 mW, that is sufficient, with an harmonic content lower than 30 dBc.

The low-pass filter F1, made simply with condensers and inductances applied on integrated circuit, avoids the residues of radio frequency. The amplifier A1 should amplify, without increasing the distortion, the signal coming from H1 ranging from the direct current up to frequencies in the order of 300 MHz (for a total synthetizer coverage of 2x300 = 600 MHz) or 1 GHz (for a coverage of 2 GHz).

The so-described component causes serious problems when it is desired a simple embodiment, therefore it is convenient to break the loop in two ways: one way from the direct current until some hundreds of KHz directed towards A5 and the other way from hundreds of KHz up to the higher band limit directed towards A1.

In the case in which it is desired to hook O4 to the same frequency of O1, by observing that the mixer H1 acts also as phase comparator, the complex A5 and F5, made-up with an integrated operational amplifier, that includes also the loop filter F5 in its circuits, is the error amplifier of the phase hooking loop and is consequently dimensioned, according to VCO sensitivity (in MHz/V) and to the characteristic of the phase comparator (in mV/rad).

In this case the microcontroller C1, by its digital output Y1, shunts the electronic commutator H4, made-up with a simple integrated circuit CMOS, connecting A5/F5 to H5.

On the contrary the microcontroller C1 shunts the commutator H4 to the other way in the case in which it is desired to bring the oscillator O4 to frequencies that show a distance of integral multiples of the reference frequency R1 from the frequency of O1 (both to higher or lower frequencies).

In this case the detection of phase errors is made by means of a sampling circuit S1.

Although it is possible to use a mixer for this aim, better performances and a greather simplicity are obained using a circuit of "sample and hold" type made-up of a sole fast MOSFET until the frequencies in the order of about 500 MHz; if higher frequencies are required, it is necessary to use Shottky diodes or mosfets. The control signal of S1 is shunted from the reference R1 by means of a pulse generating circuit P2.

It is easy to make this circuit by simple logic ports NAND or NOR with fast CMOS logics for pulses of some nSec, silicium ECLs for pulses of about 1 nSec or made of GaAs for some hundreds of pSec.

Obviuosly it is possible, also if less practical, to make this circuit by a step diode.

The assembly of P2 and S1 can be also considered as an harmonic converter in which P2 is the line generator and S1 is the mixer that makes the phase compararision.

Although the sampler S1 is suitable to process also the direct current, it was noticed that this operation is expensive, therefore the amplifier A1 shall be made with some amplification stages coupled in alternated current, from 100 KHz until the superior extreme value of the foreseen band.

The gain is about 20 dB, as the sampler must supply a signal of about 1 $V_{peak-peak}$, and the output impedance (Za) shall be as little as possible (50 Ohm are still acceptable).

It can be made with integrated circuits.

The amplifier A3 and filter F3 assembly is completely similar to A5/F5 assembly, but in this case the signal comes from the sampler S1.

The input impedance (Zb) of A3 shall be very high for not charging excessively the holding condenser (Ca) of "sample and hold" circuit S1.

If Ta is the duration of pulses and Tb is its repetition period (equal to the inverse of R1 frequency), it shall be Za*Ca $\ll$ Ta and Zb*Ca $\gg$ Tb.

The microcontroller C1 has the aim of pretuning O4 at the wished frequency with an error lower than the capture band of the phase control loop (determined substantially by the filters F3 or F5) and uses for this aim an analog output Y2 (digital/analog converters).

Instead of using the memorization of tension/frequency characteristics of O4 at the various temperatures (this operation being possible but also increasing the calibration and test operations), it is convenient to measure directly the frequency of O4 using the input of counter Z1 of C1 and considering that the frequency of O1 is known, becouse it is determined by the programming of the secondary loop.

As Z1 usually accepts rather low frequencies, at maximum 1 MHz, it is convenient to divide the output frequency at A1, that can reach 1 GHz, using the prescaler D2.

The frequency dividers require a minimum ramp time of the input signal for correctly making the division, therefore it is necessary to put upstream a squaring circuit A6, made with differential transistor stages and/or logical ports NAND or NOR.

The gain of A6 must be rather high, about 60 dB, as it must bring the ramp time of 100 uSec/V (corresponding to the lower frequency under which the loop is hooked) to 10 nSec/100 mV (corresponding to the minimum counting frequency).

Therefore it is convenient to survey during the calibration phase, also in approximative manner, the tension/frequency characteristic of VCO O4, with the aim of making the pre-tuning operations faster and avoiding the emission of spurious waves keeping off O4, and the following buffer A4, until the remaining circuit parts are aligned at the new frequency.

Therefore the main synthesis loop is well-established both in its functions and in its embodiment modality.

It can be made using simple and economic circuits, mainly purchased easily in integrated form on the market.

## The secondary synthesis loop AS

Figure 6 represents in details the secondary synthesis loop (AS), that is substantially a simple indirect synthesis loop, excepting the possibility of making some simplifications as the required synthesis band is very narrow, exactly equal to the reference frequency R1.

The more critical circuit part is the oscillator O1 as its performances directly influence the performances of the complete device.

It shall be preferably made-up with a dielectric resonator oscillator in the mode $TE_{O1d}$ for frequencies higher than 2.5 GHz and with a coaxial dielectric resonator oscillator for lower frequencies. Obviuosly the resonating elements, or cavities, can be made in many different manners, but the above indicated manners assure a suitable gain factor with a compact circuit and low microfonics.

The dielectric resonator is coupled with a varactor diode, and it shall be selected among the ones having a gain factor as high as possible and it shall be only a weak coupling in order to avoid a strong damaging of the gain of the same resonator.

The required frequency deviation is equal to the reference frequency R1 and can be easily obtained with the two osicllator types indicated above.

The oscillator does not require a mechanical tuning and this highly simplifies its embodiment, as it is not necessary to prevent all quick frequency springs, caused by material settings, that are caused by mechanical tuning.

The used active component is a bipolar transistor or a low or mean level fet.

Finally the oscillator O1 is of the low noise type and with high stability with electronic frequency control.

The programmable dividers N1 and M1 and the phase/frequency comparator K1 are normally used within a sole integrated circuit, available from various suppliers at low cost.

As the input of N1 does not normally exceeds by a limited value 1 GHz, it shall be necessary to insert upstream a fixed divider J1 commercially available from various suppliers, such as an integrated circuit mounted on silicium until 2.5 GHz or on GaAs until 14 GHz.

Further it can be made with a parametric varactor divider or with a free oscillator hooked in subharmonic frequency by injection until frequencies even higher than 20 GHz.

It can be also conceived to low-shift the frequency of O1 with a further mixer and a further oscillator, but the scheme structure should increase greatly in complexity.

The oscillator O1 can be made at frequency that is submultiple of the required frequency, that can be reached by an multiplier.

In this case its performances should however be deteriorated in terms of noise and stability by the order of the same multiplying.

The error amplifier G1, made with a sole operational low frequency amplifier includes also the loop filter L1 in its components.

Its passing band is very low, in the order of 100 MHz and in any case lower than a hundredth of the reference frequency R1 divided by M1.

It is useful to add, although unnecessary, a clamp circuit that limits the tension variation at output of A1 to some tenths of mV.

In fact in the case of loop unlocking, due e.g. to mechanical vibrations, the amplifier A1, amplifying the error, in absence of clamp, could pilot the oscillator also by some MHz out of the wished frequency, causing a running interruption of the whole device.

On the contrary the clamp circuit prevents that the oscillator is moved more than 10 KHz from the wished frequency, or also by a lower value, if it is necessary, for not interrupting the device running.

In this case the microcontroller C1 shall make the pre-tuning of the wished frequency.

It measures the indicative tension of the frequency error at output of K1 in its analog input Z2, and using its analog output Y5 it applies a tension to the sum node H6 for bringing the oscillation frequency within the loop capture band, limited by the clamp circuit.

The node H6 is simply the input, at very high impedance, of the varactor diode of O1.

Therefore the secondary synthesis loop is well established both in its functions and in its fulfilment modality.

The sole important components are the cavity oscillator and the frequency divider, but excepting these, the other components are all simple and economic, purchased easily on the market in an integrated form.

### EXPERIMENTAL TESTS

The described circuits were tested at various frequencies by the costruction of some prototypes, obtaining the formerly indicated performances.

The described alternative solutions were experienced and the selected solution, indicated before as "preferred", was chosen owing to the results of experiments that were carried out.

## Claims

1.  A generation system for high-frequency signals, included in particular in the field of microwaves, of the frequency synthesis type including: a direct synthesis section including at least an oscillator (O1), filters (L), amplifiers (A), mixers (M) and commutators (C); and an indirect synthesis section including at least a VCO (O4), a mixer (H), a filter (F), an amplifier (A), dividers (N and M) and possibly a multiplier (P), characterized in that it comprises a main loop (AP) including an oscillator O4 that is a low gain factor microwave VCO that covers the whole required band with its electronic tuning, and a secondary loop (AS) including a first indirect synthesis single-loop section (Z1) with an uncritical cavity oscillator (O1) with very high gain factor, with an electric tuning that syntetizes the fine frequency steps and controls the stability of the same O1 with a quartz reference (R1), said secondary loop (AS) further including a second section (Z2) in which the frequencies necessary to the synthesis are generated by direct way starting from said (R1).

2. A system according to claim 1, characterized in that the frequency (f4) coming from O4 and the frequency (f1) coming from O1 are mixed in a mixer (H1), whose output or intermediate frequency (fi) is filtered and amplified, and covers a band going from the zero frequency (f0) until a frequency fG in the order of 1 GHz, the oscillator O4 including now a band ranging from the frequency f1 + fG to f1 - fG, where f1 is the cavity oscillator frequency, the higher frequency steps being obtained by controlling i.e. by hooking the intermediate frequency (f1) to the multiple values of the quartz reference frequency (R1).

3. A system according to claim 1, characterized in that the second section (Z2) of the secondary loop (AS) includes a pulse generator P2 associated to R1 and a sampler S1.

4. A system according to claim 1, characterized in that said second section (Z2) of the secondary loop (AS) includes a line generator (comb-generator) instead of the pulse generator and a phase mixer/comparator instead of the sampler.

5. An oscillator for implementing the system according to the preceding claims, including a main loop (AP), an oscillator (O4), an insulator (I1), a mixer (H1), a first filter (F1), a first amplifier (A1), a sampler (S1), a second amplifier (A3) and a second filter (F3), the oscillator O4 including a transistor for low frequencies and a FET for higher frequencies, and a varactor diode, and a secondary loop having at least an oscillator (O1), a fixed divider (J1), a divider (N1), a phase comparator mixer (K1), a further divider (M1) and a microcontroller (C1).

6. Systems and oscillators substantially according to what described and represented.

FIG. 1

FIG. 2

FIG. 4

FIG. 3

FIG. 5

FIG. 6

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | US-A-4 551 689 (J. SCALA ET. AL.)<br>* column 4, line 7 - column 5, line 6; figure 4 *<br>--- | 1 | H03L7/23 |
| X | US-A-4 114 110 (E. NOSSEN)<br>* column 1, line 55 - column 2, line 55; figure 1 *<br>--- | 1 | |
| X | US-A-3 956 703 (J. NOORDANUS ET. AL.)<br>* column 3, line 54 - column 5, line 23; figure 4 *<br>--- | 1 | |
| A | US-A-5 128 633 (F. MARTIN ET. AL.)<br>* column 2, line 19 - line 55; figure 1 *<br>--- | 1 | |
| A | WO-A-84 00648 (HUGHES AIRCRAFT CO.)<br>* page 8, line 32 - page 10, line 29; figures 1,2 *<br>----- | 1 | |
| | | | TECHNICAL FIELDS SEARCHED (Int.Cl.5)<br><br>H03L<br>H03B |

The present search report has been drawn up for all claims

| Place of search | Date of completion of the search | Examiner |
|---|---|---|
| THE HAGUE | 12 January 1994 | BUTLER, N |